(19) Europäisches Patentamt
European Patent Office
Office européen des brevets

(11) **EP 4 749 302 A1**

(12) **EUROPEAN PATENT APPLICATION**

(43) Date of publication:
27.05.2026 Bulletin 2026/22

(21) Application number: 25199867.0

(22) Date of filing: 03.09.2025

(51) International Patent Classification (IPC):
*G01R 31/327* (2006.01)    *H01M 10/00* (2006.01)

(52) Cooperative Patent Classification (CPC):
**G01R 31/3277; H01M 10/42; H01M 10/44**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 20.11.2024 KR 20240166570

(71) Applicant: **SAMSUNG SDI CO., LTD.**
**Yongin-si, Gyeonggi-do 17084 (KR)**

(72) Inventor: **LEE, Jonghun**
**17084 Yongin-si, Gyeonggi-do (KR)**

(74) Representative: **Gulde & Partner**
**Patent- und Rechtsanwaltskanzlei mbB**
**Berliner Freiheit 2**
**10785 Berlin (DE)**

(54) **SWITCH LIFE PREDICTION METHOD AND SYSTEM**

(57) The present disclosure relates to a switch life prediction method and system. The switch life prediction method according to the present disclosure may be performed by the switch life prediction system (100). The switch life prediction method includes receiving current-specific usage limit count data of a target switch, generating a life prediction function according to a usage current of the target switch based on the usage limit count data, and generating a first cumulative consumption function which calculates a cumulative consumption amount of the target switch using a usage current value of the target switch as an input factor based on the life prediction function. The first cumulative consumption function may be corrected by being multiplied by a weight less than 1 in a low-current section.

FIG. 2

```
                    START
                      │
GENERATE LIFE PREDICTION FUNCTION    S210
                      │
GENERATE FIRST CUMULATIVE            S220
CONSUMPTION FUNCTION
                      │
GENERATE WEIGHT FUNCTION             S230
ACCORDING TO CURRENT
                      │
GENERATE SECOND CUMULATIVE           S240
CONSUMPTION FUNCTION
                      │
CALCULATE SECOND CUMULATIVE          S250
CONSUMPTION FUNCTION
                      │
              WARNING                S260
         THRESHOLD VALUE OR ─── NO
              MORE?
                │
               YES
         REPLACEMENT                 S270
    THRESHOLD VALUE OR ─── NO
         MORE?
                │
               YES
S280  OUTPUT REPLACEMENT MESSAGE   OUTPUT WARNING MESSAGE   S290
                      │
                     END
```

EP 4 749 302 A1

## Description

### FIELD

The present disclosure relates to a switch life prediction method and a system for executing the same.

### BACKGROUND

Secondary batteries are batteries that may be recharged and discharged, unlike primary batteries that cannot be recharged. Low-capacity rechargeable batteries are used in small portable electronic devices, such as smart phones, feature phones, notebook computers, digital cameras, and camcorders, while large-capacity rechargeable batteries are widely used as power sources for driving motors of hybrid vehicles or electric vehicles and used as power storages. A secondary battery may include an electrode assembly consisting of a positive electrode and a negative electrode, a case that accommodates the electrode assembly, a terminal part connected to the electrode assembly, etc.

A rack battery management system (BMS) may use a switch, such as a DC contactor, to protect a battery while charging and discharging a secondary battery. A switch is a component that plays an important role in electrical circuits and is used to control a large current and cut the current off for safety.

However, the switch may be worn or damaged during use, and in this case, a problem that sparks may occur at contact portions or circuits may not properly operate may occur.

Accordingly, it is important to manage the life of the switch and replace the switch. By replacing the switch at an appropriate time point, it is possible to ensure the safety of an electrical system and reduce the cost and time due to a potential failure. In addition, an important part of a preventive maintenance program is to track and manage the life of a switch, which helps increase the availability of electrical devices and reduce the possibility of a failure.

However, regardless of the nature of sites in which a secondary battery (hereinafter referred to as a "battery") is used, a case in which the life of a switch is calculated by applying a uniform formula may cause frequent maintenance work, resulting in high costs. Accordingly, there is a need for a method of accurately predicting the life of a switch.

The herein information disclosed in this Background section is for enhancement of understanding of the background of the present disclosure, and therefore, it may contain information that does not constitute a related (or prior) art.

### SUMMARY

The present disclosure is directed to providing a switch life prediction method by dividing a current flowing through the switch into a predetermined sections and reflecting the sections, and a system for executing the same.

Aspects and features of the present disclosure are not limited to those described herein, and other aspects and features not specifically mentioned herein will be clearly understood by those skilled in the art from the description of the present disclosure herein.

According to aspects of the present disclosure, there is provided a switch life prediction method including receiving, by a switch life prediction system, current-specific usage limit count data of a target switch, generating, by the switch life prediction system, a life prediction function according to a usage current of the target switch based on the usage limit count data, and generating, by the switch life prediction system, a first cumulative consumption function which calculates a cumulative consumption amount of the target switch using a usage current value of the target switch as an input factor based on the life prediction function.

In embodiments of the present disclosure, the method may further include receiving, by the switch life prediction system, usage current-specific temperature change amount data of the target switch and generating a weight function for a low-current section set based on the temperature change amount data, and may further include generating, by the switch life prediction system, a second cumulative consumption function based on the weight function and the first cumulative consumption function.

In embodiments of the present disclosure, the life prediction function may be a function based on an exponential function.

In embodiments of the present disclosure, the first cumulative consumption function may be a function which accumulates a value obtained by multiplying a reciprocal of the life prediction function by a correction factor.

In embodiments of the present disclosure, the method may further include inputting, by the switch life prediction system, an actual usage current value of the target switch into the first cumulative consumption function to calculate a consumption amount of the target switch.

In embodiments of the present disclosure, the method may further include outputting, by the switch life prediction system, a warning message when the consumption amount of the target switch (e.g., based on the first cumulative consumption function) is greater than or equal to a warning threshold value.

In embodiments of the present disclosure, generating of the weight function may further include setting, by the switch life prediction system, a low-current section of the target switch based on the usage limit count data.

In embodiments of the present disclosure, when the first cumulative consumption function is $F_c(x)$, the second cumulative consumption function is $F_c'(x)$, and the weight function is $w(x)$, $F_c'(x)$ may be $F_c(x)*w(x)$.

In embodiments of the present disclosure, the method may further include inputting, by the switch life prediction system, an actual usage current value of the target switch into the second cumulative consumption function to calculate a consumption amount of the target switch.

In embodiments of the present disclosure, the method may further include outputting, by the switch life prediction system, a warning message when the consumption amount of the target switch (e.g., based on the second cumulative consumption function) is greater than or equal to a warning threshold value.

According to aspects of the present disclosure, there is provided a switch life prediction system including a memory configured to store computer-readable instructions, and at least one processor implemented to execute the instructions.

The at least one processor is configured to receive current-specific usage limit count data of a target switch, generate a life prediction function according to a usage current of the target switch based on the usage limit count data, and generate a first cumulative consumption function which calculates a cumulative consumption amount of the target switch using a usage current value of the target switch as an input factor based on the life prediction function, by executing the instructions.

In embodiments of the present disclosure, the at least one processor may be further configured to receive usage current-specific temperature change amount data of the target switch, may be further configured to generate a weight function of a low-current section set based on the temperature change amount data, and may be further configured to generate a second cumulative consumption function based on the weight function and the first cumulative consumption function.

In embodiments of the present disclosure, the life prediction function may be a function based on an exponential function.

In embodiments of the present disclosure, the first cumulative consumption function may be a function which accumulates a value obtained by multiplying a reciprocal of the life prediction function by a correction factor.

In embodiments of the present disclosure, the at least one processor may be further configured to input an actual usage current value of the target switch into the first cumulative consumption function to calculate a consumption amount of the target switch.

In embodiments of the present disclosure, the at least one processor may be further configured to output a warning message when the consumption amount of the target switch (e.g., based on the first cumulative consumption function) is greater than or equal to a warning threshold value.

In embodiments of the present disclosure, the at least one processor may be further configured to set a low-current section of the target switch based on the usage limit count data during a process of generating the weight function.

In embodiments of the present disclosure, when the first cumulative consumption function is $F_c(x)$, the second cumulative consumption function is $F_c'(x)$, and the weight function is $w(x)$, $F_c'(x)$ may be $F_c(x)*w(x)$.

In embodiments of the present disclosure, the at least one processor may be further configured to input an actual usage current value of the target switch into the second cumulative consumption function to calculate a consumption amount of the target switch.

In embodiments of the present disclosure, the at least one processor may be further configured to output a warning message when the consumption amount of the target switch (e.g., based on the second cumulative consumption function) is greater than or equal to a warning threshold value.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

## BRIEF DESCRIPTION OF THE DRAWINGS

The herein and other objects, features and advantages of the present disclosure will become more apparent to those of ordinary skill in the art by describing exemplary embodiments thereof in detail with reference to the accompanying drawings, in which:

FIG. 1 is a block diagram illustrating a configuration of a switch life prediction system according to embodiments of the present disclosure;
FIG. 2 is a flowchart for describing a switch life prediction method according to embodiments of the present disclosure;
FIG. 3 is a graph illustrating switching life specifications according to a usage voltage and usage current of a switch;

FIG. 4 is a view illustrating a life prediction function; and

FIG. 5 is a view illustrating usage current-specific temperature change amount data of the switch.

## DETAILED DESCRIPTION

An energy storage system (ESS) is installed in various sites. Among the sites, a frequency regulation (FR) site, an uninterruptible power supply (UPS) site, and the like operate an ESS in a state in which a switch, such as a DC contactor, is always closed due to the nature of applications. In the case of the herein sites, wear due to opening and closing operations of the switch progresses slowly, and the actual number of times and time of use are much smaller than an operating time of the switch.

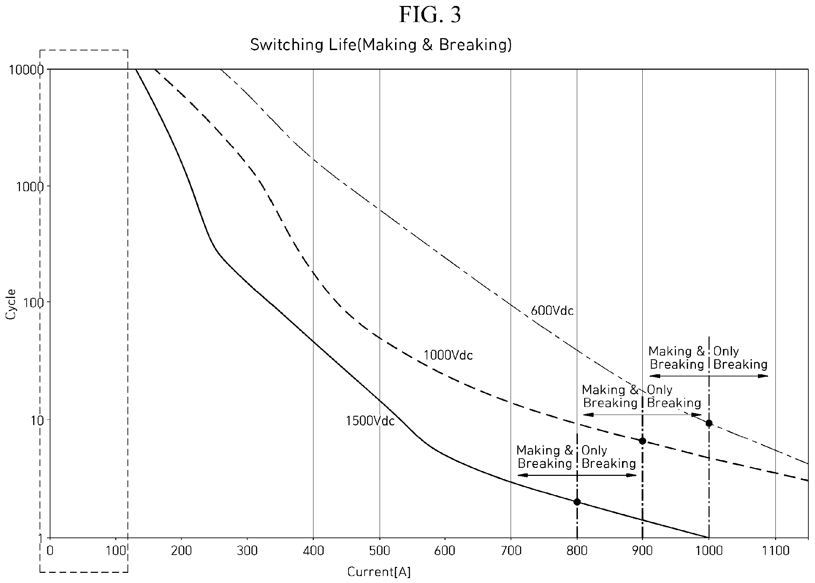

In addition, most current areas in which a switch is used in these sites correspond to a low-current section (e.g., a dotted box area in FIG. 3), and this section corresponds to a semi-permanent area in an actual switching life area. That is, when a target switch is continuously used in the low-current section, a replacement cycle may be set long.

When the switch is replaced by applying a uniform formula regardless of the number of times the switch is used or the current area, this may result in the waste of replacement costs, so it is necessary to improve a switch life prediction method considering such a point.

In the present disclosure, a "switch" may be, for example, one of a DC contactor, an AC contactor, and a relay. However, the switch of the present disclosure is not limited to the herein examples. Any component which changes the opening/closing or connection state of an electric circuit may correspond to the "switch" of the present disclosure.

Hereinafter, embodiments of the present disclosure will be described, in detail, with reference to the accompanying drawings. The terms or words used in the present specification and claims are not to be narrowly interpreted according to their general or dictionary meanings and should be interpreted as having meanings and concepts that are consistent with the technical idea of the present disclosure on the basis of the principle that an inventor can be his/her own lexicographer to appropriately define concepts of terms to describe his/her disclosure in the best way.

The embodiments described in this specification and the configurations shown in the drawings are only some embodiments of the present disclosure and do not represent all of the aspects, features, and embodiments of the present disclosure. Accordingly, it should be understood that there may be various equivalents and modifications that can replace or modify one or more embodiments or features therein described herein at the time of filing this application.

It will be understood that if an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, if a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the

EP 4 749 302 A1

other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112(a) and 35 U.S.C. § 132(a).

References to two compared elements, features, etc. as being "the same" may mean that they are "substantially the same." Thus, the phrase "substantially the same" may include a case having a deviation that is considered low in the art, for example, a deviation of 5% or less. In addition, if a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may contact the upper (or lower) surface of the element, and another element may also be interposed between the element and the arbitrary element located on (or under) the element.

In addition, it will be understood that if a component is referred to as being "linked," "coupled," or "connected" to another component, the elements may be directly "coupled," "linked" or "connected" to each other, or another component may be "interposed" between the components."

Throughout the specification, if "A and/or B" is stated, it means A, B or A and B, unless otherwise stated. That is, "and/or" includes any or all combinations of a plurality of items enumerated. When "C to D" is stated, it means C or more and D or less, unless otherwise specified.

The terminology used herein is for the purpose of describing embodiments of the present disclosure and is not intended to limit the present disclosure.

In describing the present disclosure, when it is determined that the detailed description of a related known technology may unnecessarily obscure the gist of the present disclosure, the detailed description thereof will be omitted.

Hereinafter, embodiments of the present disclosure will be described in detail with reference to the accompanying drawings. To facilitate overall understanding in the description of the present disclosure, the same reference numbers will be used for the same means regardless of drawing numbers.

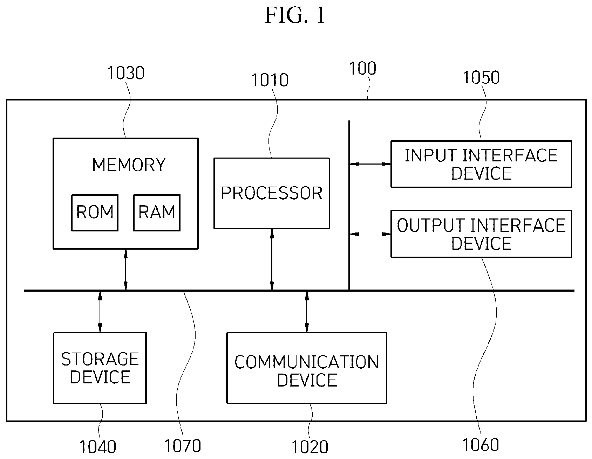

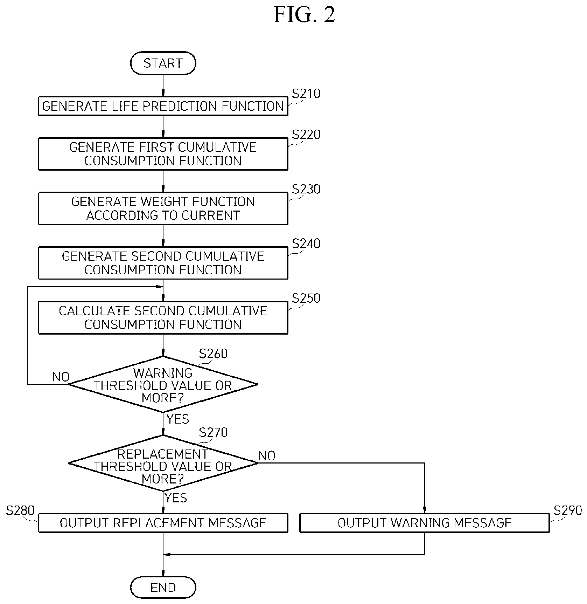

FIG. 1 is a block diagram illustrating a configuration of a switch life prediction system according to embodiments of the present disclosure. A switch life prediction system 100 may be implemented in the form of a computer system illustrated in FIG. 1. The switch life prediction system 100 performs a switch life prediction method (see FIG. 2) according to embodiments of the present disclosure.

Referring to FIG. 1, the switch life prediction system 100 may include at least one of at least one processor 1010, a memory 1030, an input interface device 1050, an output interface device 1060, and a storage device 1040 which communicate via a bus 1070. The switch life prediction system 100 may further include a communication device 1020 coupled to a network. The processor 1010 may be a central processing unit (CPU), or a semiconductor device that executes computer-readable instructions stored in the memory 1030 or the storage device 1040. The memory 1030 and the storage device 1040 may include various types of volatile or nonvolatile storage media. For example, the memory 1030 may include a read only memory (ROM) and a random access memory (RAM). In the embodiment of the present disclosure, the memory 1030 may be located inside or outside the processor 1010, and the memory 1030 may be connected to the processor 1010 through various known means. The memory 1030 may include various types of volatile or nonvolatile storage media, and for example, the memory 1030 may include a ROM or a RAM.

Accordingly, the embodiment of the present disclosure may be implemented as a method implemented on a computer or as a non-transitory computer-readable medium storing computer-executable instructions. In embodiments, when executed by the processor 1010, the computer-readable instructions may perform a method according to at least one aspect of the present disclosure.

The communication device 1020 may transmit or receive a wired signal or a wireless signal.

In addition, the switch life prediction method according to the embodiment of the present disclosure may be implemented in the form of program instructions which may be performed through various computer devices and recorded on a computer-readable medium.

The computer-readable medium may include program instructions, data files, data structures, and the like alone or in combination. The program instructions recorded on the computer-readable recording medium may be specially designed and configured for the embodiments of the present disclosure or may be known and available to those skilled in the field of computer software. The computer-readable recording medium may include a hardware device configured to store and perform the program instructions. For example, the computer-readable recording medium may include magnetic media such as a hard disk, a floppy disk, and a magnetic tape, optical media such as a CD-ROM and a DVD, and magneto-optical media such as a floptical disk, a ROM, a RAM, and a flash memory. The program instructions include not only machine language code such as that produced by a compiler but also high-level language code that may be executed by a computer using an interpreter or the like.

The processor 1010 is configured to receive current-specific usage limit count data of a target switch by executing computer-readable instructions stored in the memory 1030 or the storage device 1040, generate a life prediction function according to a usage current of the switch based on the usage limit count data, and generate a first cumulative consumption function which calculates the cumulative consumption of the target switch using a usage current value of the target switch as an input factor based on the life prediction function. The life prediction function may be a function based on an exponential function, and the first cumulative consumption function may be a function which accumulates a value obtained by multiplying a reciprocal of the life prediction function by a correction factor.

The processor 1010 may be configured to receive usage current-specific temperature change amount data of the target switch, generate a weight function for a low-current section set based on the temperature change amount data, and generate a second cumulative consumption function based on the weight function and the first cumulative consumption function. When the first cumulative consumption function is $F_c(x)$, the second cumulative consumption function is $F_c'(x)$, and the weight function is $w(x)$, $F_c'(x)$ may be $F_c(x)*w(x)$.

The processor 1010 may be configured to input an actual usage current value of the target switch into the first cumulative consumption function to calculate a consumption amount of the target switch.

The processor 1010 may be configured to output a warning message when the consumption amount of the target switch is greater than or equal to a warning threshold value.

The processor 1010 may be configured to set a low-current section of the target switch based on the usage limit count data during the process of generating the weight function.

The processor 1010 may be configured to input the actual usage current value of the target switch into the second cumulative consumption function to calculate a consumption amount of the target switch.

The processor 1010 may be configured to output a warning message when the consumption amount of the target switch is greater than or equal to a warning threshold value.

FIG. 2 is a flowchart for describing a switch life prediction method according to embodiments of the present disclosure. Description of FIG. 2 will be given with reference to FIGS. 3 to 5.

For the convenience of description, it is assumed that the switch life prediction method illustrated in FIG. 2 is performed by the switch life prediction system 100.

Referring to FIG. 2, the switch life prediction method according to embodiments of the present disclosure includes operations S210 to S290. The switch life prediction method according to embodiments is illustrated in FIG. 2, and the operations of the switch life prediction method according to the present disclosure are not limited to the embodiment illustrated in FIG. 2 and may be added, changed, or omitted as needed. For example, in the switch life prediction method of FIG. 2, operations S230 and S240 may be omitted, and in this case, operation S250 may be changed to an operation of calculating the consumption amount of the target switch using the first cumulative consumption function.

Operation S210 is an operation of generating the life prediction function.

The switch life prediction system 100 receives the current-specific usage limit count data of the target switch. The usage count refers to the number of times the target switch is opened and closed.

FIG. 3 is a graph illustrating switching life specifications (usage limit count) according to an operating voltage and usage current of a switch, and the usage limit count data may be given as in the example of FIG. 3. FIG. 3 is a graph illustrating the switching life specifications according to the operating voltage and usage current of the switch and illustrates usage limit count data according to the usage current. The usage limit count may vary depending on the operating voltage. The dotted box portion of FIG. 3 is a low-current section and indicates that the target switch may be used semi-permanently when operating in the corresponding section. Accordingly, it is necessary to focus on this low-current section when predicting the life of the target switch and determining a replacement time point.

The switch life prediction system 100 generates a life prediction function according to the usage current of the target switch based on the usage limit count data.

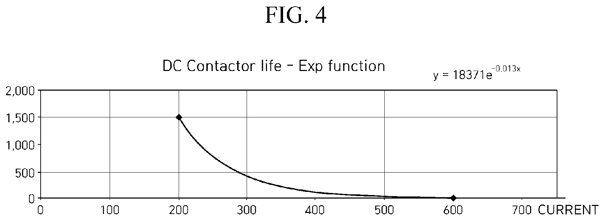

For example, the switch life prediction system 100 may generate the life prediction function by fitting an exponential function using a usage limit count graph of an operating voltage of 1500 Vdc in FIG. 3 (see FIG. 4). In FIG. 4, an x-axis represents current, and a y-axis represents the usage limit count. FIG. 4 is an exemplary view illustrating a current and a usage limit count for a DC contactor among switches.

That is, the life prediction function may be a function based on an exponential function, and in this case, the life prediction function may be represented by Equation 1.

[Equation 1]

$$Life(x) = a \cdot e^{-bx}$$

In Equation 1, x denotes a usage current of a target switch, and a and b denote coefficients.

Operation S220 is an operation of generating the first cumulative consumption function.

The switch life prediction system 100 may generate the first cumulative consumption function based on the life prediction function generated in operation S210. The first cumulative consumption function is a function which calculates a cumulative consumption amount of the target switch using the usage current value of the target switch as an input factor.

The first cumulative consumption function may be a function which accumulates a value obtained by multiplying the reciprocal of the life prediction function by a correction factor. That is, the first cumulative consumption function may be represented by Equation 2.

[Equation 2]

$$F(x) = \sum \left( \frac{d}{Life(x)} \right)$$

The first cumulative consumption function may be accumulated periodically or accumulated every time opening/closing operations are performed, and an accumulation time point of the first cumulative consumption function may be set according to the characteristics of an ESS site to which the target switch is applied.

Operation S230 is an operation of generating the weight function according to a current.

As described herein, since the consumption amount of the target switch is low in the low-current section, it is necessary to apply a small weight to the first cumulative consumption function in the low-current section.

The switch life prediction system 100 may set the low-current section of the target switch based on the settings of a user or the usage limit count data input in operation S210.

For example, the switch life prediction system 100 may set a current section having a usage limit count higher than a predetermined threshold value as the low-current section. In FIG. 3, when the operating voltage is 1500 Vdc, a section in which the usage limit count is greater than 10000 is a section of [0, 100], and the switch life prediction system 100 may set this section as the low-current section. In addition, when the threshold value of the usage limit count is set to 2000 at the same operating voltage, the switch life prediction system 100 sets a section of [0, 200] as the low-current section.

The switch life prediction system 100 may use usage current-specific temperature change amount data of the target switch when generating a weight function for the low-current section. That is, the switch life prediction system 100 may receive the usage current-specific temperature change amount data of the target switch and generate the weight function for the low-current section set based on the temperature change amount data.

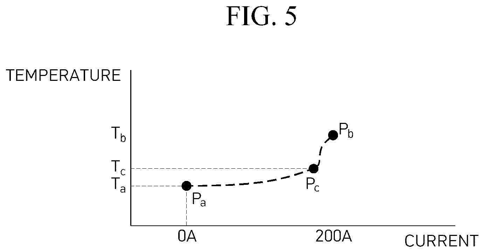

FIG. 5 is a view illustrating usage current-specific temperature change amount data of the switch.

The low-current section may be represented by $[i_{base}, i_{ref}]$. $i_{base}$ may be set to 0 when no current flows in the target switch. $i_{ref}$ denotes a reference current and is a maximum value of the low-current section.

The temperature change amount data in the low-current section [0, 200] is as illustrated in FIG. 5. In FIG. 5, a temperature of the target switch when a current is 0 A is $T_a$, and a temperature of the target switch when the reference current (200 A) flows is $T_b$. That is, $P_a$ is $(0, T_a)$ and $P_b$ is $(200, T_b)$. $P_c$ may be represented by $(x, T_c)$. In this case, a weight for a current value x may be represented by Equation 3.

[Equation 3]

$$w = \frac{T_c - T_a}{T_b - T_a}$$

When Equation 3 is generalized, the weight function w(x) for the current value x in the low-current section may be represented by being generalized as in Equation 4. Temp(·) denotes a function which fits the current-specific temperature change amount data into a formula.

[Equation 4]

$$w(x) = \frac{Temp(x) - Temp(i_{base})}{Temp(i_{ref}) - Temp(i_{base})}$$

Accordingly, the weight function w(x) outputs a value between 0 and 1.

As another example, the switch life prediction system 100 may use a table including a current and a weight instead of the weight function.

Meanwhile, the switch life prediction system 100 may collect temperature data of the target switch while the target switch is in use and update the weight function and the second cumulative consumption function, which will be described herein, based on the collected temperature data.

Operation S240 is an operation of generating the second cumulative consumption function.

The switch life prediction system 100 generates the second cumulative consumption function based on the weight function and the first cumulative consumption function.

For example, when the first cumulative consumption function is $F_c(x)$, the second cumulative consumption function is $F_c'(x)$, and the weight function is w(x), the second cumulative consumption function may be represented by Equation 5.

[Equation 5]

$$F_c'(x) = w(x) \cdot F_c(x)$$

As another example, the low-current section may be divided into a predetermined number of subsections, and the same weight may be given to a current value included in each subsection.

For example, the switch life prediction system 100 may divide a low-current section [0, $i_{ref}$] into subsections of [0, $i_1$], [$i_1$, $i_2$], [$i_2$, $i_{ref}$], and $i_{ref}$ according to an input or settings of a user and apply the following second cumulative consumption function.

[Equation 6]

$$F_c'(x) = \begin{cases} 0, if\ x \in [0, i_1) \\ w(i_1) \cdot F_c(x), if\ x \in [i_1, i_2) \\ w(i_2) \cdot F_c(x), if\ x \in [i_2, i_{ref}) \\ F_c(x), if\ x = i_{ref} \end{cases}$$

Operations S250 to S290 are operations which use the second cumulative consumption function generated in operation S240 in order to determine the replacement time point of the target switch during a process of actually using the target switch.

Operation S250 is an operation of calculating the second cumulative consumption function. The switch life prediction system 100 inputs an actual usage current value of the target switch into the second cumulative consumption function to calculate the consumption amount of the target switch.

The second cumulative consumption function may be accumulated periodically or accumulated every time opening and closing operations are performed, and a reference (a cycle or a usage time point of the target switch) for the accumulation time point of the second cumulative consumption function may be set by the user or the switch life prediction system 100 according to the characteristics of an ESS site to which the target switch is applied.

Then, the switch life prediction system 100 determines whether the calculated consumption amount of the switch is greater than or equal to the warning threshold value and/or greater than or equal to a replacement threshold value (S260 and S270), outputs a warning message when the consumption amount is greater than or equal to the warning threshold value but smaller than the replacement threshold value (S290), and outputs a replacement message when the consumption is greater than or equal to the replacement threshold value (S280).

When the consumption amount is smaller than the warning threshold value, operation S250 is continuously performed.

The switch life prediction method has been described with reference to the flowchart presented in the drawing. For simplicity, the method has been illustrated and described as a series of blocks, but the present disclosure is not limited to the order of the blocks, some blocks may occur in a different order or simultaneously with other blocks illustrated and described herein, and various other branches, flow paths, and block orders that achieve the same or similar results may be implemented. In addition, not all of the illustrated blocks may be required for implementing the method described herein.

Meanwhile, in the description with reference to FIG. 2, each operation may be further subdivided into additional operations or combined into fewer operations according to embodiments of the present disclosure. In addition, some operations may be omitted as needed, or the order between the operations may be changed. In addition, although other contents are omitted, the content of FIG. 1 may be applied to the content of FIG. 2. In addition, the contents of FIGS. 2 to 5 may be applied to the content of FIG. 1.

For reference, the components according to embodiments of the present disclosure may be implemented in the form of software or hardware such as a digital signal processor (DSP), a field programmable gate array (FPGA), or an application specific integrated circuit (ASIC) and may perform certain roles.

However, the "components" are not limited to software or hardware, and each component may be configured to reside on an addressable storage medium or configured to reproduce one or more processors.

Accordingly, as an example, the components include components such as software components, object-oriented software components, class components, and task components, processes, functions, attributes, procedures, subroutines, segments of program code, drivers, firmware, microcode, circuits, data, databases, data structures, tables, arrays, and variables.

Components and the functions provided in the corresponding components may be combined into fewer components or further separated into additional components.

Meanwhile, it will be understood that each block of flowcharts in the drawings and combinations of the flowcharts in the diagrams may be performed by computer program instructions. Since these computer program instructions may be installed on a processor of a general-purpose computer, a special-purpose computer, or other programmable data processing equipment, the instructions executed by the processor of the computer or other programmable data processing equipment generate a means for performing functions described in the block(s) of the flowchart. Since the computer program instructions may also be installed on a computer or other programmable data processing equipment, a series of operational steps are performed on the computer or other programmable data processing equipment to generate a computer-executable process so that instructions executing the computer or other programmable data processing equipment may provide operations for executing the functions described in the block(s) of the flowchart.

In addition, each block may represent a module, a segment, or a part of code which includes one or more executable instructions for executing a specific logical function(s). In addition, it should be noted that in some alternative implementation examples, the functions described in the blocks may be performed out of order. For example, two blocks illustrated in succession may actually be executed substantially at the same time, or the blocks may sometimes be executed in reverse order according to the corresponding function.

According to embodiments of the present disclosure, it is possible to reduce maintenance costs by appropriately predicting the life of a switch according to a site in which a battery is used.

Specifically, according to embodiments of the present disclosure, it is possible to reduce the cost of a maintenance company's trip, the cost according to the shutdown of the corresponding site, and the cost required for replacing the switch.

However, effects of the present disclosure are not limited to the hereindescribed effects, and other technical effects that are not mentioned will be clearly understood by those skilled in the art to which the present disclosure pertains from the description of the disclosure herein.

Although the present disclosure has been described herein with reference to exemplary embodiments, those skilled in the art will understand that the present disclosure may be modified and changed in various ways without departing from the scope of the present disclosure as described in the appended claims.

**Claims**

1. A switch life prediction method comprising:

   receiving, by a switch life prediction system (100), current-specific usage limit count data of a target switch;
   generating, by the switch life prediction system (100), a life prediction function according to a usage current of the target switch based on the usage limit count data; and
   generating, by the switch life prediction system (100), a first cumulative consumption function which calculates a cumulative consumption amount of the target switch using a usage current value of the target switch as an input factor based on the life prediction function.

2. The switch life prediction method as claimed in claim 1, wherein the life prediction function is a function based on an exponential function.

3. The switch life prediction method as claimed in claim 1 or 2, wherein the first cumulative consumption function is a function which accumulates a value obtained by multiplying a reciprocal of the life prediction function by a correction factor.

4. The switch life prediction method as claimed in any one of the preceding claims, further comprising inputting, by the switch life prediction system (100), an actual usage current value of the target switch into the first cumulative consumption function to calculate a consumption amount of the target switch.

5. The switch life prediction method as claimed in claim 4, further comprising outputting, by the switch life prediction system (100), a warning message when the consumption amount of the target switch based on the first cumulative consumption function is greater than or equal to a warning threshold value.

6. The switch life prediction method as claimed in any one of the preceding claims, further comprising:

   receiving, by the switch life prediction system (100), usage current-specific temperature change amount data of the target switch and generating a weight function for a low-current section set based on the temperature change amount data; and
   generating, by the switch life prediction system (100), a second cumulative consumption function based on the weight function and the first cumulative consumption function.

7. The switch life prediction method as claimed in claim 6, wherein generating of the weight function further comprises setting, by the switch life prediction system (100), a low-current section of the target switch based on the usage limit count data.

8. The switch life prediction method as claimed in claim 6 or 7, wherein, when the first cumulative consumption function is $F_c(x)$, the second cumulative consumption function is $F_c'(x)$, and the weight function is $w(x)$, $F_c'(x)$ is $F_c(x)*w(x)$.

9. The switch life prediction method as claimed in any one of claims 6 to 8, further comprising inputting, by the switch life prediction system (100), an actual usage current value of the target switch into the second cumulative consumption function to calculate a consumption amount of the target switch.

10. The switch life prediction method as claimed in claim 9, further comprising outputting, by the switch life prediction system (100), a warning message when the consumption amount of the target switch based on the second cumulative consumption function is greater than or equal to a warning threshold value.

11. A switch life prediction system (100) comprising:

    a memory (1030) configured to store computer-readable instructions; and
    at least one processor (1010) implemented to execute the instructions,
    wherein the at least one processor (1010) is configured to:

receive current-specific usage limit count data of a target switch;

generate a life prediction function according to a usage current of the target switch based on the usage limit count data; and

generate a first cumulative consumption function which calculates a cumulative consumption amount of the target switch using a usage current value of the target switch as an input factor based on the life prediction function, by executing the instructions.

12. The switch life prediction system (100) as claimed in claim 11, wherein the at least one processor (1010) is further configured to:

receive usage current-specific temperature change amount data of the target switch;

generate a weight function of a low-current section set based on the temperature change amount data; and

generate a second cumulative consumption function based on the weight function and the first cumulative consumption function.

13. The switch life prediction system (100) as claimed in claim 11 or 12, wherein the life prediction function is a function based on an exponential function.

14. The switch life prediction system (100) as claimed in any one of claims 11 to 13, wherein the first cumulative consumption function is a function which accumulates a value obtained by multiplying a reciprocal number of the life prediction function by a correction factor.

15. The switch life prediction system (100) as claimed in any one of claims 11 to 14, wherein the at least one processor (1010) is further configured to input an actual usage current value of the target switch into the first cumulative consumption function to calculate a consumption amount of the target switch.

FIG. 1

## FIG. 2

START

GENERATE LIFE PREDICTION FUNCTION — S210

GENERATE FIRST CUMULATIVE CONSUMPTION FUNCTION — S220

GENERATE WEIGHT FUNCTION ACCORDING TO CURRENT — S230

GENERATE SECOND CUMULATIVE CONSUMPTION FUNCTION — S240

CALCULATE SECOND CUMULATIVE CONSUMPTION FUNCTION — S250

WARNING THRESHOLD VALUE OR MORE? — S260 — NO / YES

REPLACEMENT THRESHOLD VALUE OR MORE? — S270 — NO / YES

OUTPUT REPLACEMENT MESSAGE — S280

OUTPUT WARNING MESSAGE — S290

END

# FIG. 3

## Switching Life(Making & Breaking)

EP 4 749 302 A1

FIG. 4

DC Contactor life – Exp function $y = 18371e^{-0.013x}$

FIG. 5

Europäisches Patentamt
European Patent Office
Office européen des brevets

# EUROPEAN SEARCH REPORT

**Application Number**

EP 25 19 9867

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/209312 A1 (KIM JINHWAN [KR]) 2 July 2020 (2020-07-02) | 1,5,11 | INV. G01R31/327 |
| A | * paragraph [0015] - paragraph [0048]; claim 1 * | 2-4, 6-10, 12-15 | H01M10/00 |
| A | LI KUI ET AL: "Electrical Performance Degradation Model and Residual Electrical Life Prediction for AC Contactor", IEEE TRANSACTIONS ON COMPONENTS, PACKAGING AND MANUFACTURING TECHNOLOGY, IEEE, USA, vol. 10, no. 3, 13 January 2020 (2020-01-13), pages 400-417, XP011777507, ISSN: 2156-3950, DOI: 10.1109/TCPMT.2020.2966516 [retrieved on 2020-03-09] * the whole document * | 1-15 | |
| A | CN 202 676 873 U (UNIV SHENYANG TECHNOLOGY) 16 January 2013 (2013-01-16) * paragraph [0037] - paragraph [0062] * | 1-15 | TECHNICAL FIELDS SEARCHED (IPC) |
| A | RU 2 550 337 C2 (MALAFEEV SERGEJ IVANOVICH [RU]; TIKHONOV JURIJ VASIL EVICH [RU]) 10 May 2015 (2015-05-10) * paragraph [0008] - paragraph [0048] * | 1-15 | G01R H01M |
| A | CN 116 908 674 A (CHUAN KAI ELECTRIC CO LTD; CHENGDU TEZHIHUI ENERGY TECH CO LTD ET AL.) 20 October 2023 (2023-10-20) * paragraph [0062] - paragraph [0107] * | 1-15 | |

The present search report has been drawn up for all claims

| Place of search | Date of completion of the search | Examiner |
|---|---|---|
| Munich | 26 February 2026 | Meggyesi, Zoltán |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P4C01)

## ANNEX TO THE EUROPEAN SEARCH REPORT
## ON EUROPEAN PATENT APPLICATION NO.

EP 25 19 9867

This annex lists the patent family members relating to the patent documents cited in the above-mentioned European search report.
The members are as contained in the European Patent Office EDP file on
The European Patent Office is in no way liable for these particulars which are merely given for the purpose of information.

26-02-2026

| Patent document cited in search report | | | Publication date | Patent family member(s) | | | Publication date |
|---|---|---|---|---|---|---|---|
| US 2020209312 | A1 | | 02-07-2020 | CN | 110809720 | A | 18-02-2020 |
| | | | | EP | 3644076 | A1 | 29-04-2020 |
| | | | | JP | 7334887 | B2 | 29-08-2023 |
| | | | | JP | 2020527228 | A | 03-09-2020 |
| | | | | KR | 20190041259 | A | 22-04-2019 |
| | | | | PL | 3644076 | T3 | 14-03-2022 |
| | | | | US | 2020209312 | A1 | 02-07-2020 |
| | | | | WO | 2019074254 | A1 | 18-04-2019 |
| CN 202676873 | U | | 16-01-2013 | NONE | | | |
| RU 2550337 | C2 | | 10-05-2015 | NONE | | | |
| CN 116908674 | A | | 20-10-2023 | NONE | | | |

EPO FORM P0459

For more details about this annex : see Official Journal of the European Patent Office, No. 12/82